# EUROPEAN PATENT SPECIFICATION

(11) **EP 2 567 290 B1**
(45) Date of publication and mention of the grant of the patent: **10.07.2019**
(21) Application number: 11717604.0
(22) Date of filing: 29.04.2011
(51) Int. Cl.: G03F 7/00, B82Y 10/00, B82Y 40/00

(54) **FABRICATION OF NANOMETER AND MICROMETER STRUCTURES WITH CONTINUOUS RELIEFS**
HERSTELLUNG VON NANOMETER- UND MIKROMETERSTRUKTUREN MIT KONTINUIERLICHEN RELIEFS
FABRICATION DES STRUCTURES NANOMÉTRIQUES ET MICROMÉTRIQUES AVEC DES RELIEFS CONTINUS

(30) Priority: 07.05.2010 EP 10162352
(43) Date of publication of application: 13.03.2013
(73) Proprietor: Paul Scherrer Institut, 5232 Villigen PSI (CH)
(72) Inventor: SCHIFT, Helmut, CH-2503 Biel (CH); SCHLEUNITZ, Arne, 10627 Berlin (DE)
(74) Representative: Fischer, Michael
(86) International application number: PCT/EP2011/056818
(87) International publication number: WO 2011/138237

(56) References cited:
- WO-A1-2006/109907
- US-A1- 2003 224 253
- US-A1- 2004 229 409
- US-A1- 2006 079 017
- KUO-SHEN CHEN ET AL: "Fabrication of 3D polymer microstructures using electron beam lithography and nanoimprinting technologies; Fabrication of 3D polymer microstructures using electron beam lithography and nanoimprinting technologies", JOURNAL OF MICROMECHANICS & MICROENGINEERING, INSTITUTE OF PHYSICS PUBLISHING, BRISTOL, GB, vol. 15, no. 10, 1 October 2005 (2005-10-01), pages 1894-1903, XP020091379, ISSN: 0960-1317, DOI: 10.1088/0960-1317/15/10/015
- KIM ET AL: "Controlling resist thickness and etch depth for fabrication of 3D structures in electron-beam grayscale lithography", MICROELECTRONIC ENGINEERING, ELSEVIER PUBLISHERS BV., AMSTERDAM, NL, vol. 84, no. 12, 19 November 2007 (2007-11-19), pages 2859-2864, XP022350508, ISSN: 0167-9317, DOI: 10.1016/J.MEE.2007.02.015

## Description

The present invention relates to a method for fabricating nanometer and micrometer structures with continuous surfaces and slopes using thermally reflowed photoresist technology
Electron beam lithography (EBL) allows three dimensional (3-D) patterning by using modulated-dose exposure and adapted wet development. Depending on the dose *D* deposited in the depth of the resist, the molecular weight *M_{w}* of the polymer, in a positive resist such as poly(methyl methacrylate) (PMMA), is reduced in the exposed areas. This allows the removal of parts of the exposed resist with a high *M_{w}* selectivity due to their varied ability to dissolve in the developer, while the non-exposed resist stays unaltered. The depth of the development is determined by using a specific development time *t_{dev}* in a low contrast developer, which exhibits a *M_{w}* dependent etch rate. Thus, multilevel staircase structures can be generated if the dose variation in adjacent exposure fields results in a sufficiently distinct *M_{w}* variation. High depth will be achieved in locations with high *M_{w}* and low depth in locations with low *M_{w}*. Due to narrow beam and low scattering they will be laterally and vertically separated with sharp corners.

In addition to lithography, thermal reflow techniques can be used as a simple and well established post-processing method for modifying the shape of a binary (i.e. two-level) resist structure fabricated by photolithography (PL) or EBL into a 3-D shape. Resist melting and mass-transport of typical thermoplastic photoresists are already widely used for the fabrication of spherical or cylindrical lenses in the micrometer range with very smooth surfaces in wafer scale. When heated over its glass transition temperature *T_{g},* the resist changes into a viscous state and surface tension leads to the formation of a surface of least energy (surface of minimum area). In reflow was also used for roughness reduction.

In mass transport was done with micrometer sized multilevel structures. Prismatic gallium phosphide optics with smooth sidewalls and 8.2 µm high, 100 µm long slopes (with 4.7° angle) were created from five 1.6 µm high, 20 µm wide steps. Here, instead of heating of the entire structure, local heating by laser exposure was used. This had the advantages that only the surface part of the structure deforms while the other part remains unaltered.

For the state of the art, it is referred to Chen, Kuo-Shen & Lin, Ikuan & Ko, Fu-Hsang. (2005). Fabrication of 3D polymer microstructures using electron beam lithography and nanoimprinting technologies. Journal of Micromechanics and Microengineering. 15. 1894. 10.1088/0960-1317/15/10/015.

It is the aim of the present invention to provide a method for fabricating nanometer and micrometer structures with continuous surfaces and slopes using thermally reflowed photoresist technology allowing to improve the process route for the fabrication of 3D structure.

This aim is achieved according to the present invention by a method for fabricating nanometer and micrometer structures with continuous surfaces and slopes using thermally reflowed photoresist technology, comprising the following steps:
(i) coating of one or more layers of polymer on a substrate, where at least one of the polymer layers is a radiation sensitive resists with specific high molecular weight which can be transferred into low molecular weight by electron beam exposure; or where the material is a crosslinked polymer, from which only the exposed entities will be transferred into polymers able to flow;
(ii) heating of the photoresist layer;
(iii) using photolithography with a high accelerating voltage in an electron beam direct writing manner to expose a pattern on said layer of photoresist for forming a pattern made from different local doses; the molecular weight is modified according to the dose;
   wherein the radiation sensitive resist after exposure contains different molecular weights, at least one layer of polymer has a molecular weight below and one layer of polymer above 10k, wherein these two layers of polymer have different glass transitions;
(iv) using a developer and an etchant for developing and etching in order to form a recess area in the exposed areas; due to the different molecular weights, the etch speed is different and thus the etching depth in vertical direction;
(v) stopping the developing at a specific time to obtain a height profile according to the doses;
(vi) because of the limited time for development, which is determined by the time needed for the structures with the highest doses to be completely etched away, the photoresist is only partially removed in area with lower doses;
(vi) after the etching of the photoresist, reflowing the photoresist within a predetermined period of time and temperature, such that the part of the photoresist with a glass temperature lower than the temperature begins to flow; depending on the temperature used, and the difference of the local glass temperature with respect to the temperature, different states are obtained in the same resist; and
(vii) after obtaining the surface relief with stepped and continuous structures by reflow, etching the photoresist into the underlying substrate using plasma based reactive ion etching processes with no significant dependence on the molecular weight thereby etching highly anisotropic and proportional in depth.

These process steps represent a new process route for the fabrication of 3D structures which exhibit both sharp and continuous profiles. This was previously not feasible by standard grayscale EBL which is restricted to manufacture only (quasi-) multistep patterns. The new method is based on the combination of grayscale EBL with a moderate thermal reflow process. The 3-D originals were fabricated by modulated-dose EBL structure in polymeric resist with lateral resolutions below 200 nm, and thermal reflow was effectuated by global heating at moderate temperatures.

The present invention can be further developed by one or a combination of the following process steps:
- said layer of photoresist is a PMMA (polymethyl methacrylate) photoresist or another radiation sensitive photoresist;
- the material is a glass-like material such as biopolymer such as polylactate;
- the initial molecular weight of PMMA ranges from 15k to 2000k, including crosslinked PMMA resists with high initial molecular weight;
- the material is a photoresists containing PMMA, PMGI, and P(MMA-MAA), polystyrene;
- the material is a photoresists containing HSQ and sol-gel materials;
- said layer of photoresist is generated by spincoating from a solution or by dispensing of droplets, spraycoating, dipping, lamination;
- wherein several layers of photoresist with different chemical composition or molecular weight are used;
- said photoresists are at least two layers of multi-layered photoresists structure containing PMMA, LOR, PMGI, and P(MMA-MAA), polystyrene;
- one or more layers of photoresist are resists with very low sensitivity to said electron beam radiation which means layers not to be removed after development, e.g. so-called lift-of resist (LOR);
- the photoresist is a foil or plate, preferably thicker than 5 µm, or a free standing polymer film, preferably 100 nm and thicker, instead of resist on a substrate;
- the photoresist is a wire, tube, or any non-planar substrate material instead of resist on a substrate
- the photoresist is a polymer plate and foil or thin film which is laminated, e.g. by so-called reversal imprint;
- the photoresist has a thickness with different resist heights from 20nm to 100 µm, preferably from 30nm to 50µm;
- the multilayer contains different initial molecular weights, at least one layers has molecular weight below and one above 10k, which have different glass transitions;
- electron beam or x-ray or proton or plasma exposure with modulated dose is used;
- if the resist is a negative resist, i.e. starting to crosslink when exposed, e.g. polystyrene is positive resist at low doses, but crosslinks at very high doses; starting with a resist of molecular weight below 10k
- if the resist is already patterned, a flood exposure with electron beam or X-ray will reduce the resist in the non-exposed areas which will reduce the high molecular weight;
- said step of removing the photoresists employs MIBK and IPA to develop said photoresists;
- said developer is a mixture of MIBK:IPA=1:1;
- said developer is a mixture of MIBK:IPA=1:2;
- said developer is a mixture of MIBK:IPA=1:3;
- a time dependent development is used in standard wet development including also automated developing machines with abrupt stopping of development;
- the resist after exposure contains different molecular weights, at least one layers has molecular weight below and one above 10k, which have different glass transitions;
- the reflow temperature is chosen near the lowest glass transition temperature to smoothen out surfaces roughness;
- the reflow temperature is chosen below the highest and above the lowest glass transition temperature to smoothen out surfaces roughness
- the reflow temperature is chosen above the highest transition temperature to re-melt all the structures, including the non-exposed areas;
- a structure with high (lens-like continuous slope is created out from a structure with up to 100 levels in the photoresist;
- a linear slope is created out from more than one level in the photoresist;
- a lens-like continuous slope is created out from a structure with up to 100 levels in the photoresist;
- reflow is done by global heating (not only surface or particular locations) by using a hot plate or oven heating manner;
- heating of the photoresist layer is done by way of using a local heating with laser irradiation, microwaves and local heaters;
- heating of the surface of the photoresist layer is done by way of using a hot stamp and applying pressure;
- modulated reflow is fostered due to local differences in viscosity at a fixed temperature with respect to molecular weight;
- a control of an contact angle is achieved using modification of surface energy;
- the bottom layer is either a non-developed part of the resist, a non-sensitive resist layer or a specific substrate;
- the bottom layer is either silicon or silicon oxide thereby obtaining a sharp border of the resist;
- said predetermined period of time and temperature for the reflow of said photoresists are 60 seconds and 115°C., respectively, and the heating manner employs a bottom heating manner;
- said resist profile is transferred by pattern transfer into a hard material by etching of the substrate, e.g. by proportional etching using a reactive ion etching machine (RIE) ;
- said pattern transfer is characterized by the same etching rate with an etch ratio between substrate and resist of 1;
- said pattern transfer is characterized by the same etching rate with an etch ratio between substrate and resist of different 1, thus enabling the proportional amplification or reduction of structure profiles;
- said pattern transfer is characterized by the same etching rate and a polymer to substrate etch ratio independent of molecular weight;
- the etching process is also valid for substrate materials such as glass, silicon nitride, other isolators;
- the etching process is also valid for substrate materials such as metal or graphite or other conductors;
- the pattern transfer is done using replication, using electroforming (galvanics) and/or casting (PDMS, sol-gel, polymers) and/or injection molding and/or hot embossing;
- the pattern transfer of sloped structures is used to define the substrate windows of different depths due to sloped sidewalls and a variation of etching time;
- continuous structures with lateral structural details from 10 nm to 1 mm, relief depths from 10nm to 10µm in electron beam resist are used
- a slope from 1° to 89° (measurable deviation from horizontal and vertical case), such as a saw tooth structure, is formed in a 500 nm thick resist having 20 steps with 25 nm height increment
- a combination of steep (90°, non-reflowed) and sloped (inclined) walls in the same profile is used;
- a combination of many different angles at one probe in vicinity;
- very fine structural details are achieved by smoothening effect due to capillary forces;
- a fabrication of continuous surface reliefs from an original structures with a few steps is used, i.e. minimum 2 steps above the substrate height - not binary, as in normal reflow;
- at the same time reflow lenses, such as cylindrical and spherical structures, e.g. as holders for fixation/alignment of optical elements such as fibers, and classical reflow for lens structures along with non-reflowed structures is used;
- a steep linear slope of nearly 85 up to 89 but not 90° is created; said slopes are inclined sidewalls and facilitate detachment of a mold from a molded polymer layer in a so-called nanoimprint lithography demolding process similar to injection molding and roll embossing; and
- a steep linear slope with negative slope is generated in a double layer with high molecular weight on top and a low molecular weight at the bottom, which after developments results in an stepped undercut.

Preferred examples of the present invention are described hereinafter with more detail with respect to the attached tables and drawings:
- Figure 1: shows a process chain or schematic where different 3-D shapes can be achieved from an e-beam exposed resist structure by choosing the appropriate reflow temperature.
- Figure 2: shows a contrast curve in 500 nm thick PMMA 950k (development time of 60sec with developer IPA:MIBK 1:1).
- Figure: 3 shows a reflow temperature study with a stepped pyramid with 4 exposure dose levels at a) 25, b) 100, c) 110, d) 115, e) 120 and f) 140 °C.
- Figure 4: is a schematic of *M_{w}* distribution after EBL and polymer behavior during reflow process at different temperatures; a) Structure after electron beam lithography and development, b) smoothening, c) beginning of reflow, and d) development of slope.
- Figure 5: is a characterization of sloped sidewall achieved by 4-level EBL (initial steps indicated in profile) and reflow at 120 °C for 15 min, with an angle α = 10.7°.
- Figure 6: shows a silicon stamp fabrication by proportional pattern transfer using RIE; both staircase profiles (left) and continuous sidewalls (right) are faithfully transferred into the silicon substrate.

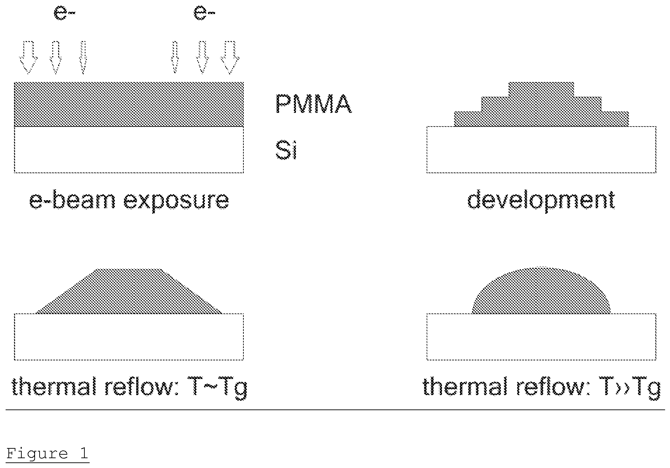

The process scheme is depicted in Fig. 1 from left to right in two columns. First step is coating of one or more layers of polymer PMMA on a substrate Si, where at least one of the polymer layers is a radiation sensitive resists with specific high molecular weight which can be transferred into low molecular weight by electron beam exposure; or where the material is a crosslinked polymer, from which only the exposed entities will be transferred into polymers able to flow. The coated photoresist layer is heated and photolithography with a high accelerating voltage in an electron beam direct writing manner is used to expose a pattern on said layer of photoresist for forming a pattern made from different local doses; the molecular weight is modified according to the dose. The upper right picture represents the step of using a developer and an etchant for developing and etching in order to form a recess area in the exposed areas; due to the different molecular weights, the etch speed is different and thus the etching depth in vertical direction which is shown by the stair-like structure. Then the developing is stopped at a specific time to obtain a height profile according to the doses (stair-profile). Because of the limited time for development, which is determined by the time needed for the structures with the highest doses to be completely etched away, the photoresist is only partially removed in area with lower doses.

The lower left picture represents the step of reflowing the photoresist within a predetermined period of time and temperature, such that the part of the photoresist with a glass temperature lower than the temperature begins to flow; depending on the temperature used, and the difference of the local glass temperature with respect to the temperature, different states are obtained in the same resist.

Finally, after obtaining the surface relief with stepped and continuous structures by reflow, the photoresist is etched into the underlying substrate using plasma based reactive ion etching processes with no significant dependence on the molecular weight thereby etching highly anisotropic and proportional in depth.

Thermal reflow was applied in microstructures with local *M_{w}* modulation. This allows reflowing the areas with low *M_{w},* while others stay insensitive to reflow due to their high *M_{w}*. For high cylindrical resist pillars in PMMA by deep X-ray lithography (DXRL), X-ray flood exposure was used as post-processing to reduce the molecular weight at the top of the structure while the bottom remained almost unexposed. The local absorption in the pillars was chosen in a way that the threshold for the *M_{w}* and consequently a low enough viscosity *η₀(T)* needed for reflow was reached in the upper part of the pillar. During reflow, only the top of a cylindrical pillar was melted and resulted in a pillar with a high base cylinder and a spherical top.

In x-ray exposure, photons are absorbed following an exponential absorption law, thus resulting in a continuous decrease of dose down to the bottom of the resist. In contrast to this, for high-energy electron beams and thin films, as was used in the investigations described here, the absorbed energy density is approximately uniform in the full depth of resist. This is particularly valid for the thin (below 1 µm) resist structures and the 100 keV electrons used here, with low forward scattering into adjacent areas. As in XRL, in EBL linear polymers with high *M_{w}* of 50k and higher are exposed (k means kg/mol). In both cases, after exposure, *M_{w}* below 10k is needed to enable the attack of the appropriate developer.

In the following, some further parameters from different sources serve as guidelines for process evaluation and interpretation and enable to judge the orders of magnitudes of effects. It has to be pointed out that it is not the intention to give a conclusive picture about all effects, or to provide exact quantitative data on *M_{w}, T_{g}* or viscosity *η₀*(*T*) for the PMMA resist used here.

E.g. it is known that the *T_{g}* of PMMA can vary significantly between 85 to 165 °C due to the vast number of commercial compositions . E.g. for isotactic PMMA one finds values of 120°C, while for molding applications, e.g. nanoimprint lithography (NIL), PMMA of *M_{w}* 25 or 75k with a typical *T_{g}* of 105 °C is used. One can also find for isotactic PMMA, that the *T_{g}* for low *M_{w}* is much lower than for higher *M_{w},* i.e. for 1.45k, 4.9k, 11k, 21k and 55.9k, *T_{g}s* of 42, 93, 118, 119 and 121 °C were measured, respectively. This was also found for a typical EBL resist. Note that while for lower *M_{w}* than 10k a drop in *T_{g}* is happening, above 10k no significant dependence of *T_{g}* on *M_{w}* can be found. The *M_{w}* of 10k needed for development after EBL exposure is exactly in the range of where large difference in *T_{g}* can be found. This is in accordance with the minimum *Mₑ,* above which entanglement of PMMA chains becomes significant, since there are only 100 monomer entities. This is particular important if PMMA has to be molded in its viscous state, i.e. above the *T_{g},* where chain mobility is increasing due to a loss of entanglement. Therefore we anticipate here, that a similar behavior is found in all kinds of PMMA.

For NIL as well as for standard reflow, another property becomes important. Here, process temperatures are chosen in the purely viscous flow regime (between *T_{g}* and *T_{f})* above a flow temperature *T_{f},* which is 30 to 60°C above *T_{g},* at which the viscosity is low enough to ensure flow. For entangled polymers (*T_{g}* above 10k), it is known that this *T_{f}* is dependent on *M_{w},* while *T_{g}* is considered as almost independent on *M_{w}*. This means that for standard reflow processes, *M_{w}* modulations will result in differences in flow. One can find that also the viscosity for low *M_{w}* is much lower than for higher *M_{w},* e.g. for 7, 26, 71, 151 and 396k viscosities of 2,100, 66,810, 101000, 167,400 and 421,000 Pa·s were measured at 200°C and shear rate *γ̇* of 10 s⁻¹. The values for 26k and for 71k are 10 to 20 times higher than those measured which shows that dependency on polydispersity *M_{w}*/*Mₙ,* tacticity or experimental tolerances have to be taken into account.

The fragmented polymer chains with low *M_{w}* after e-beam exposure are almost independent of the initial *M_{w}* if the initial *M_{w}* is higher than 50k. The *M_{w}* of PMMA resists used in EBL is usually larger than 50k, therefore this rule applies. Then, for the threshold dose for development *Dₘᵢₙ* of PMMA used in EBL, the high initial *M_{w}* needs to be reduced to below 10k. It was also found that the (*M_{w}*)⁻¹ is linear with dose, meaning that if 10% is the minimum dose needed for development for the smallest step, for 100% the *M_{w}* will be even 10 times smaller, i.e. 7k for 10% dose and 700 for 100% dose. Because of the fact that the *M_{w}* is below 10k for both cases, the full dose and the attenuated case, one therefore anticipate here that both *T_{g}* and *T_{f}* will be dependent on *M_{w},* furthermore the visco-elastic flow regime (between *T_{g}* and *T_{f}*) will be rather limited, and significant flow can be achieved already at relatively low temperatures above *T_{g},* or more precisely, *T_{g}*(*M_{w}*)*.* Since in this publication we are interested to modify EBL exposed, multilevel structures with in a "global", i.e. a full wafer non-localized heating process, one needs to take these assumptions into account. Note that for the parameters chosen for the current research, as will be described in the following, the etching speed is not proportional to the dose, and consequently not to (*M_{w}*)⁻¹.

This means exposure of almost any high *M_{w}* resist results in quite low *M_{w},* and therefore it can be anticipated that by exposing a specific pixel area A(x,y), its properties can be defined according to the following chain: higher *Dₑₓₚ*(x,y) → lower *M_{w}*(x,y) → lower *T_{g}*(x,y) and lower *T_{f}*(x,y) → lower *η₀*(x,y,*T*). Without the aim to provide exact quantitative data on local *M_{w}* and *η₀*, one can sketch the process needed to achieve reflow in EBL exposed multilevel structures: (a) Temperatures for reflow should be chosen as low as possible, to keep the overall shape of the original and avoid melting of bulky structures. (b) The difference in flow depending on *M_{w}* should low enough to ensure a homogeneous smoothening on each level, but *T* should be controllable to an extent that different states from smoothening to melting can be achieved in a controlled way. As already shown in the prior art, the shape should be controllable either by design (e.g. line or dot), flow restrictions (i.e. forming of a defined meniscus, available volume), chemical barriers (high surface energy), temperature (within a range of a few degrees) or careful setting of time (in a continuous evolution within a time window of 1 to 10 min a stopping at exact states of reflow should be possible).

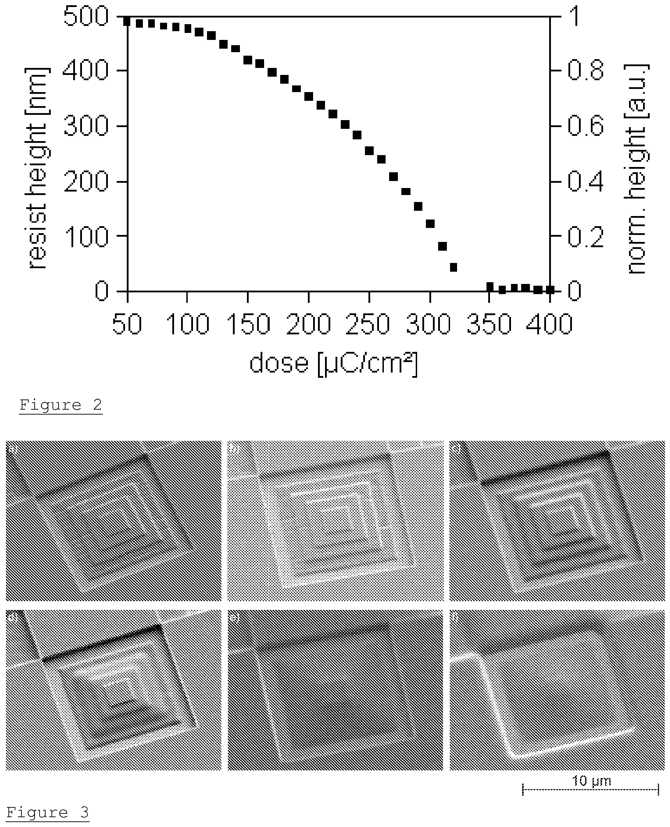

Hereinafter some experimental results are disclosed. All structures have been fabricated in a classical PMMA EBL resist (Allresist 679.04) with *M_{w}* of 950k, and a thickness of 500 nm. Its *T_{g}* was measured to be 118°C. After the exposure (VISTEC EPBG 5000+ at 100keV), samples were developed in a methyl-isobutyl-ketone (MIBK) mixed with one part of isopropylalcohol (IPA) to obtain a low contrast in a Hamatech spray developer at room temperature, and rinsed in IPA for additional 30 sec. A dose variation from 0 to 400 µC/cm² was performed in order to determine the dose-depth correlation. Fig. 2 shows that for the specific development procedure (developer mixture and duration) the dose for which complete development was achieved (so-called dose-to-clear) was 325 µC/cm².Here, no PMMA residues remain at the silicon substrate after development. Then test exposures with reduced doses were used to calibrate a dose-depth relation (see Fig. 2). Using this, in a 500 nm thick resist, up to 20 levels with equal depth increments could be fabricated using doses from 50 to 350 µC/cm² (in the following, we will denominate this "attenuated" case). The smallest depth increment was measured to be 25 nm, and a minimum step size of 200 nm was achieved. While the precision of these steps could be controlled within a few percent, a roughness pattern was observed which corresponds partially with the exposure fields defined by the EBL exposure software. Using Scanning Force Microscopy (SFM), the depth of this roughness was determined to be around 10 nm. For the following experiments, the exposure setup was not optimized to remove this roughness, but kept it as a means for improving the effectiveness of the post-processing.

For reflow the resist structures were put on a hot plate and left heated in ambient conditions at a constant temperature. The resist was hardened by instant cooling when the desired shape was achieved. For a better examination the reflow has to be controlled over time. It was therefore started with reduced reflow temperature *T_{reflow}* below the known original *T_{g},* here of 118°C, to avoid rapid collapsing of structures, and observe structure evolution over time. Higher temperatures lead to more rapid reflow, but also to a more pronounced deformation of the entire structures. A process window was defined to be between 100 and 140°C (here 15 min process time). These process steps are shown in Fig. 3, with a pyramid with 4 steps in a 585 nm high resist with lateral step sizes of 1 µm:
a+b) for temperatures below and up to 100°C, no shape deformation due to the thermal treatment was observed;
c) at 110°C, the onset of smoothening of surface roughness can be seen, surface roughness due to EBL exposure and development is smoothened out;
d) at 115°C: smoothening is complete and onset of structural deformation can be seen (particularly at the corners). Non-exposed areas can still be clearly distinguished from exposed areas;
e) at 120°C: steps of a few 10 up to 100 nm are deformed and smooth continuous surfaces appear. Non-exposed areas can still be distinguished from exposed areas, suggesting that there is still no flow within non-exposed areas at this temperature, but corners are slightly smoothened out;
f) at 140°C: entire structures are deformed with smooth continuous surfaces. Non-exposed areas are also beginning to be deformed;

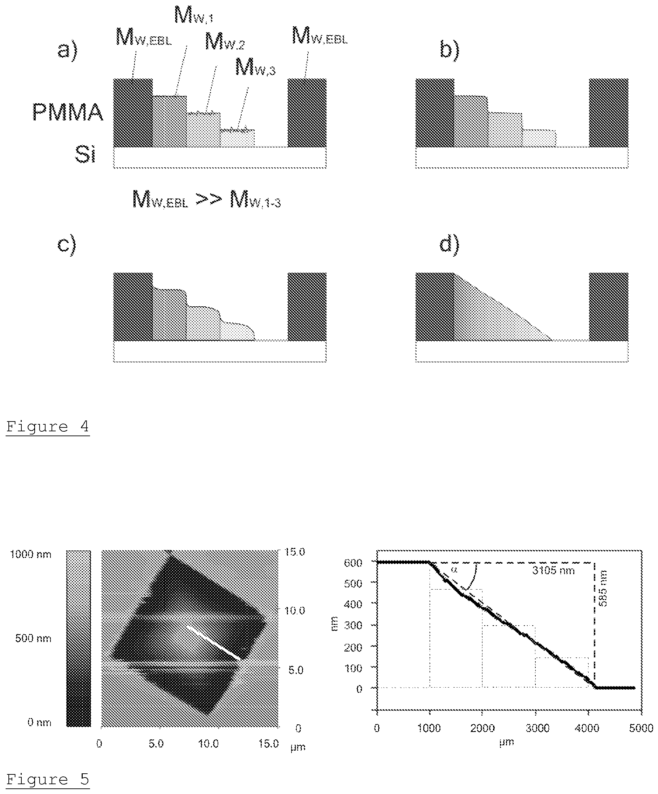

At first glance, the process latitude for reflow is large enough to allow the modification of an original multi-step structure in different ways. For the relatively shallow microstructures shown here, with step sizes around 10 times larger than step depths, the experiments show a quite distinct behavior. There are five areas of interest (see Fig. 4):
a) Fig. 4a: A stepped structure is generated after exposure and development with locally different and clearly distinguished *M_{w}*. The dose and development time was adjusted that for highest (100%) dose, the polymer of (*M_{w4}*) is completely removed. In contrast to this, the non-exposed polymer with *M_{wEBL},* was not attacked. In areas with *Mw₁, M_{w2},* and *M_{w3},* the etch rate was smaller than in the area of highest dose, and residual polymer of different heights is covering the substrate.
b) Fig. 4b: The sharp step between exposed and non-exposed structures, even for very low (10%) dose (*M_{w1}*), demonstrates that *η₀*(*T*) is significantly lowered in the exposed areas. Taking into account that for measurement published in the prior art typical doses resulted in *M_{w}* of lower than 10k, the *T_{g}* and accordingly the *T_{f}* of exposed and non-exposed structures may be different to an extent, that within 5°C temperature difference a flow regime can be found, where non-exposed areas can still be considered as hard, while exposed areas are already subjected to viscous flow. These sharp edges can be helpful if structures with pronounced and sharp features have to be fabricated, i.e. sawtooth gratings with asymmetric shape and vertical sidewalls. However, the smoothening of these corners should be possible by blurred exposure. Smoothening seems to be complete for roughness and grooves with lower than 10 nm depth. Since this smoothening will also affect sharp corners, it is obvious that structural details below 10 nm will be lost during this process. The smoothening is due to capillary action which tends to minimize the surface. It is expected that this process is nearly viscous since the *M_{w}* is very low, but will be rather self-limiting in areas with roughness.
c) Fig. 4c: At higher temperatures the smoothening of the steps between the different levels seems to be slightly different. I.e. the steps at the upper levels are sharper than at the lower levels. This is probably due to the fact that the *M_{w}* at the lower levels is lower than in the upper levels, and therefore the viscosity lower at a given temperature. The range of this variation can probably be controlled to some extend during exposure. If only a smoothening of roughness is needed, the aim should be to take the lowest temperature possible for smoothening and to enlarge the time until flow is terminated. Because of the equal tendency that 90° corners grooves will be rounded in the same way as grooves are filled from the side, rounding in the range of the size of grooves has always to be taken into account. However, larger structures will tend to stay as they are.
d) Fig. 4d: At the bottom of the lowest level, the structure is shaper than between the different levels. This is due to the fact, that at the polymer-substrate interface, the difference in surface energy of polymer towards the substrate (e.g. silicon) determines the contact angle. This can be avoided if the lowest level is not completely removed during development, i.e. slightly below the maximum dose. In contrast to this, the surface energy can be modified by choosing the appropriate substrate or by modifying the surface by plasma treatment or deposition of a hydrophobic coating with molecular vapor deposition (MVD) before reflow
e) Fig. 5: Currently, with the actual process parameters, a complete smoothening of surface steps, i.e. the formation of a continuous profile can be achieved from the non-exposed down to the 10% dose level. For the 4-exposure doses structure in Fig. 4, the linearity of seems to be fine (see measurement in Fig. 5), and corners are not any more visible (apart from the central non-exposed pillar). The slope is around 10°. Here, the minimum of step (or level) number has to be clarified which ensures the forming of a continuous profile. It can be anticipated that there is an optimum of number of steps, increment and step size for which this linearity can be improved. The reason, that rather a linear slope than a meniscus between the steps is formed, lies in the fact that there is volume conservation at very small distances, and there is not significant polymer flow in the bulk. It is even possible that smaller features (such as corners) have an even lower *T_{g}* than the bulk, which would explain this tendency to smoothen out corners. Then we need enough flow that steps can be smoothened out, but have to restrict flow from one step to the next one.

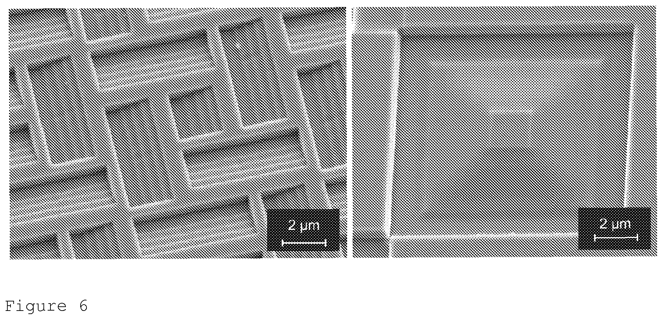

Fig. 6 shows the transfer of the resist structure into silicon using a standard reactive ion etching (RIE) process developed for proportional pattern transfer. The ICP-RIE (Oxford ICP 100) etching process had an etch rate of 50 nm/min. The *M_{w}* variation does not affect the etching rate, which demonstrates that it is determined rather by the density than the length of the PMMA chains, since their chemical nature is still very similar. The high (non-exposed) *M_{w}* in the center and the low (exposed) *M_{w}* at the border of the structure is etched with an etch ratio of 1. However, care has to be taken that the low *M_{w}* is not heated over its *T_{g}* during RIE processing and more volatile products are generated with very low *M_{w}*.

The results clearly show the versatility of the process for the generation of various surface profiles not possible with standard lithographies. Its main advantage is that with a global process and volume conservation, structures can be generated which are not or not easy to fabricate with other methods. The limitations of the process have still to be explored; currently we are obtaining smooth structures with very shallow shapes (10°). Along with the *M_{w}* dependence of the flow, both sharp corners (and high resolution) and smooth structures can be fabricated on the same substrate in close vicinity, simply by varying the local exposure dose. It is also possible that both slopes (e.g. with different angles over steps of a few to 100's of µm) as well as steep (vertical) structures can be fabricated with a single (global) process on full wafer. This would be particularly interesting for asymmetric tooth structures, e.g. for blazed gratings with inclined teeth.

The final aim is to control the complete process chain, i.e. to clarify the dependence of dose to viscosity, but also to simulate the flow during thermal treatment. The latter is particularly difficult for structures with local *M_{w}* modulation, because not only lateral etching during development, but also lateral flow between areas of different *M_{w}* has to be taken into account. Tolerances and *M_{w}* distribution will also play a role. Whether the minimum resolution can be improved, is more a question of the optimizing the EBL and development process than of the reflow. However, as it is known from other lithographies, there are certainly design restrictions to be considered, e.g. that nanostructures cannot be fabricated in attenuated areas. A trade-off between rounding and resolution is present. Currently, the possibility to control the process within a few degrees temperature is sufficient to fabricate structures for a range of applications, most prominently optical elements with defined diffractive and refractive properties. These applications range from the improved optical surfaces, where post-processing is used to smoothen out defects and roughness, to holographic structures with continuous profiles and higher diffraction efficiencies.

Possible applications are:
a) Blazed gratings, i.e. linear or dot like periodic structures with at least one slope (inclined sidewall), so-called sawtooth; inclinations at will;
b) asymmetric gratings, but also pyramidal, cone-like structures. For optical applications, templates for biological cell growth (control of direction of growth); nanophotonics at which slopes or roughness is needed;
c) Lenses with large variety of shapes and profiles, e.g. aspherical lenses; convex and concave shapes, phase correction elements; lenses with continuous and abrupt structures (cut lenses) in same substrates; combination of diffractive and refractive optics;
d) Stamps with inclined (almost vertical) sidewalls for better demolding;
e) double-sided optics, i.e. polymer can be reflown even when coated on two sides of a substrate;
f) Magnetic structures in which vertical sidewalls have to be avoided to reduce or avoid crossstalk;
g) Stamps for nanoimprint lithography, fabricated using pattern transfer (even with variation of molecular weight) or casting (negative);
h) Interference filters with long wedges;
i) Calibration structures for AFM with long wedges;
j) Calibration structures for AFM with inclined sidewalls;
k) Lenses with posts used as spacers;
l) Lenses with posts used as alignment features and mechanical registration;
m) Prisms for coupling of light into waveguides; and
n) Lens arrays with convex and concave shapes.

## Claims

1. A method for fabricating nanometer and micrometer structures with continuous surfaces and slopes using thermally reflowed photoresist technology, comprising the following steps:
(i) coating of one or more layers of polymer on a substrate, where at least one of the polymer layers is a radiation sensitive resists with specific high molecular weight which can be transferred into low molecular weight by electron beam exposure; or where the material is a crosslinked polymer, from which only the exposed entities will be transferred into polymers able to flow;
(ii) heating of the photoresist layer;
(iii) using photolithography with a high accelerating voltage in an electron beam direct writing manner to expose a pattern on said layer of radiation sensitive resist for forming a pattern made from different local doses; the molecular weight is modified according to the dose; wherein the radiation sensitive resist after exposure contains different molecular weights, at least one layer of polymer has a molecular weight below and one layer of polymer above 10k, wherein these two layers of polymer have different glass transitions;
(iv) using a developer and an etchant for developing and etching in order to form a recess area in the exposed areas; due to the different molecular weights, the etch speed is different and thus the etching depth in vertical direction;
(v) stopping the developing at a specific time to obtain a height profile according to the doses;
(vi) because of the limited time for development, which is determined by the time needed for the structures with the highest doses to be completely etched away, the photoresist is only partially removed in area with lower doses;
(vi) after the etching of the photoresist, reflowing the photoresist within a predetermined period of time and temperature, such that the part of the photoresist with a glass temperature lower than the temperature begins to flow; depending on the temperature used, and the difference of the local glass temperature with respect to the temperature, different states are obtained in the same resist; and
(vii) after obtaining the surface relief with stepped and continuous structures by reflow, etching the photoresist into the underlying substrate using plasma based reactive ion etching processes with no significant dependence on the molecular weight thereby etching highly anisotropic and proportional in depth.

2. The method according to claim 1, wherein said layer of photoresist is a PMMA (polymethyl methacrylate) photoresist or another radiation sensitive photoresist.

3. The method according to claim 1, wherein the material is a glass-like material such as biopolymer such as polylactate.

4. The method according to claim 2 wherein the initial molecular weight of PMMA ranges from 15k to 2000k, including crosslinked PMMA resists with high initial molecular weight.

5. The method according to claim 1 wherein the material is a photoresists containing PMMA, PMGI, and P(MMA-MAA), polystyrene.

6. The method according to claim 1 wherein the material is a photoresists containing HSQ and sol-gel materials.

7. The method according to claim 1, wherein said layer of photoresist is generated by spincoating from a solution or by dispensing of droplets, spraycoating, dipping, lamination.

8. The method according to claim 1, wherein several layers of photoresist with different chemical composition or molecular weight are used.

9. The method according to claim 8 wherein said photoresists are at least two layers of multi-layered photoresists structure containing PMMA, LOR, PMGI, and P(MMA-MAA), polystyrene.

10. The method according to claim 8 or 9 wherein one or more layers of photoresist are resists with very low sensitivity to said electron beam radiation which means layers not to be removed after development, e.g. so-called lift-of resist (LOR).

11. The method according to claim 1 wherein the photoresist is a foil or plate, preferably thicker than 5 µm, or a free standing polymer film, preferably 100 nm and thicker, instead of resist on a substrate.

12. The method according to claim 1 wherein the photoresist is a wire, tube, or any non-planar substrate material instead of resist on a substrate.

13. The method according to claim 1 wherein the photoresist is a polymer plate and foil or thin film which is laminated, e.g. by so-called reversal imprint.

14. The method according to claim 1 wherein the photoresist has a thickness with different resist heights from 20nm to 100 µm, preferably from 30nm to 50µm.

15. The method according to claim 1 wherein the layers contain different initial molecular weights, at least one layer has molecular weight below and one above 10k, which have different glass transitions.

## Patentansprüche

1. Verfahren zur Herstellung von Nanometer- und Mikrometerstrukturen mit kontinuierlichen Flächen und Schrägen unter Verwendung von Photoresisttechnik mit thermischem Aufschmelzen, das die folgenden Schritte umfasst:
(i) Beschichten eines Substrats mit ein oder mehr Polymerschichten, wobei mindestens eine Polymerschicht ein strahlungsempfindlicher Resist mit einem spezifischen, hohen Molekulargewicht ist, das durch Elektronenstrahlbelichtung in ein niedriges Molekulargewicht überführt werden kann, oder wobei das Material ein vernetztes Polymer ist, aus dem nur die belichteten Einheiten in Polymere, die fließen können, überführt werden,
(ii) Erhitzen der Photoresistschicht,
(iii) Verwenden von Photolithographie mit einer hohen Beschleunigungsspannung in einem Elektronenstrahldirektschreibverfahren, um ein Muster auf der Schicht von strahlungsempfindlichem Resist zu belichten zum Bilden eines aus unterschiedlichen örtlichen Dosen gefertigten Musters; das Molekulargewicht wird der Dosis entsprechend geändert, wobei der strahlungsempfindliche Resist nach der Belichtung unterschiedliche Molekulargewichte umfasst, mindestens eine Polymerschicht ein Molekulargewicht unter und eine Polymerschicht über 10.000 hat, wobei diese beiden Polymerschichten unterschiedliche Glasübergänge haben,
(iv) Verwenden eines Entwicklers und eines Ätzmittels zum Entwickeln und Ätzen, um in den belichteten Bereichen einen vertieften Bereich zu bilden, wobei aufgrund der unterschiedlichen Molekulargewichte die Ätzgeschwindigkeit und somit die Ätztiefe in vertikaler Richtung verschieden ist,
(v) Anhalten des Entwickelns zu einem bestimmten Zeitpunkt, um ein Höhenprofil entsprechend den Dosen zu erhalten,
(vi) aufgrund der begrenzten Zeit für die Entwicklung, die durch die für das vollständige Wegätzen der Strukturen mit höheren Dosen benötigte Zeit bestimmt wird, wird der Photoresist in Bereichen mit niedrigeren Dosen nur teilweise entfernt,
(vi) nach dem Ätzen des Photoresists Aufschmelzen des Photoresists innerhalb einer vorbestimmten Zeit und Temperatur, sodass der Teil des Photoresists mit einer Glastemperatur, die niedriger ist als die Temperatur, zu fließen beginnt und je nach der verwendeten Temperatur und dem Unterschied der lokalen Glastemperatur in Bezug auf die Temperatur in dem gleichen Resist unterschiedliche Zustände erreicht werden, und
(vii) nach dem Erhalten des Oberflächenreliefs mit abgestuften und kontinuierlichen Strukturen Ätzen des Photoresists in das darunterliegende Substrat unter Verwendung von plasmabasierten, reaktiven Ionenätzungsprozessen ohne signifikante Abhängigkeit von dem Molekulargewicht, wodurch sehr anisotrop und in der Höhe proportional geätzt wird.

2. Verfahren nach Anspruch 1, wobei die Schicht von Photoresist ein PMMA (Polymethylmethacrylat)-Photoresist oder ein anderer strahlungsempfindlicher Photoresist ist.

3. Verfahren nach Anspruch 1, wobei das Material ein glasähnliches Material, z. B. ein Biopolymer wie Polylactat ist.

4. Verfahren nach Anspruch 2, wobei das anfängliche Molekulargewicht des PMMA im Bereich von 15.000 bis 2.000.000 liegt, einschließlich vernetzter PMMA-Resists mit einem hohen anfänglichen Molekulargewicht.

5. Verfahren nach Anspruch 1, wobei das Material ein Photoresist ist, der PMMA, PMGI und P(MMA-MAA), Polystyrol enthält.

6. Verfahren nach Anspruch 1, wobei das Material ein Photoresist ist, der HSQ- und Sol-Gel-Materialien enthält.

7. Verfahren nach Anspruch 1, wobei die Schicht von Photoresist durch Schleuderbeschichten aus einer Lösung oder durch Ausgeben von Tropfen, Sprühbeschichten, Eintauchen, Laminierung erzeugt wird.

8. Verfahren nach Anspruch 1, wobei mehrere Schichten von Photoresist mit unterschiedlicher chemischer Zusammensetzung oder unterschiedlichem Molekulargewicht verwendet werden.

9. Verfahren nach Anspruch 8, wobei die Photoresists mindestens zwei Schichten einer mehrschichtigen Photoresiststruktur sind, die PMMA, LOR, PMGI und P(MMA-MAA), Polystyrol enthält.

10. Verfahren nach Anspruch 8 oder 9, wobei ein oder mehr Schichten von Photoresist Resists mit sehr geringer Empfindlichkeit für die Elektronenstrahlbelichtung sind, was bedeutet, dass Schichten nach der Entwicklung nicht zu entfernen sind, z. B. sogenannter Lift-Off Resist (LOR).

11. Verfahren nach Anspruch 1, wobei der Photoresist statt eines Resists auf einem Substrat eine Folie oder Platte, vorzugsweise dicker als 5 µm, oder ein frei stehender Polymerfilm, vorzugsweise 100 nm und dicker, ist.

12. Verfahren nach Anspruch 1, wobei der Photoresist statt eines Resists auf einem Substrat ein Rohr, Draht oder irgendein nicht-planares Substratmaterial ist.

13. Verfahren nach Anspruch 1, wobei der Photoresist eine Polymerplatte und -folie oder ein dünner Film ist, der laminiert wird, z. B. durch sogenanntes Umkehrprägen.

14. Verfahren nach Anspruch 1, wobei der Photoresist eine Dicke mit unterschiedlichen Resisthöhen von 20 nm bis 100 µm, vorzugsweise von 30 nm bis 50 µm, aufweist.

15. Verfahren nach Anspruch 1, wobei die Schichten unterschiedliche anfängliche Molekulargewichte enthalten, wobei mindestens eine Schicht ein Molekulargewicht unter und eine über 10.000 hat, die unterschiedliche Glasübergänge haben.

## Revendications

1. Procédé pour fabriquer des structures nanométriques et micrométriques avec des surfaces continues et des pentes à l'aide de la technologie de résine photosensible thermiquement refondue, comprenant les étapes suivantes :
(i) le revêtement d'une ou de plusieurs couches de polymère sur un substrat, où au moins l'une des couches de polymère est une réserve sensible aux rayonnements avec une masse moléculaire élevée spécifique qui peut être transférée dans une faible masse moléculaire par exposition à un faisceau d'électrons ; ou où le matériau est un polymère réticulé, à partir duquel seules les entités exposées seront transférées dans des polymères aptes à s'écouler ;
(ii) le chauffage de la couche de résine photosensible ;
(iii) l'utilisation de la photolithographie avec une tension d'accélération élevée d'une manière consistant en l'écriture directe par faisceau d'électrons afin d'exposer un motif sur ladite couche de réserve sensible aux rayonnements pour former un motif réalisé à partir de différentes doses locales ; la masse moléculaire est modifiée selon la dose ; dans laquelle la réserve sensible aux rayonnements après exposition contient différentes masses moléculaires, au moins une couche de polymère a une masse moléculaire au-dessous et une couche de polymère au-dessus de 10 k, dans laquelle ces deux couches de polymère ont des transitions vitreuses différentes ;
(iv) l'utilisation d'un révélateur et d'un agent de gravure pour révéler et graver dans le but de former une zone en creux dans les zones exposées ; en raison des différentes masses moléculaires, la vitesse de gravure est différente et ainsi la profondeur de gravure dans la direction verticale ;
(v) l'arrêt de la révélation à un moment spécifique afin d'obtenir un profil de hauteur selon les doses ;
(vi) du fait du temps limité pour la révélation, lequel est déterminé par le temps nécessaire pour que les structures avec les doses les plus élevées soient complètement ôtées par gravure, la résine photosensible est seulement partiellement retirée dans la zone avec des doses inférieures ;
(vi) après la gravure de la résine photosensible, la refusion de la résine photosensible au sein d'une période de temps et à une température prédéterminées, de telle sorte que la partie de la résine photosensible avec une température vitreuse inférieure à la température commence à s'écouler ; en fonction de la température utilisée, et de la différence de la température vitreuse locale par rapport à la température, différents états sont obtenus dans la même réserve ; et
(vii) après l'obtention du relief de surface avec des structures étagées et continues par refusion, la gravure de la résine photosensible à l'intérieur du substrat sous-jacent à l'aide de processus de gravure par ions réactifs à base de plasma sans dépendance significative de la masse moléculaire, gravure de ce fait hautement anisotrope et proportionnelle en profondeur.

2. Procédé selon la revendication 1, dans lequel ladite couche de résine photosensible est une résine photosensible de PMMA (méthacrylate de polyméthyle) ou une autre résine photosensible sensible aux rayonnements.

3. Procédé selon la revendication 1, dans lequel le matériau est un matériau vitreux tel qu'un biopolymère tel que le polylactate.

4. Procédé selon la revendication 2, dans lequel la masse moléculaire initiale du PMMA est comprise dans la gamme allant de 15 k à 2 000 k, incluant des réserves de PMMA réticulées avec une masse moléculaire initiale élevée.

5. Procédé selon la revendication 1 dans lequel le matériau est une résine photosensible contenant du PMMA, du PMGI, et du P(MMA-MAA), du polystyrène.

6. Procédé selon la revendication 1 dans lequel le matériau est une résine photosensible contenant du HSQ et des matériaux sol-gel.

7. Procédé selon la revendication 1, dans lequel ladite couche de résine photosensible est engendrée par revêtement à la tournette à partir d'une solution ou par distribution de gouttelettes, revêtement par pulvérisation, immersion, stratification.

8. Procédé selon la revendication 1, dans lequel plusieurs couches de résine photosensible avec une composition chimique ou masse moléculaire différente sont utilisées.

9. Procédé selon la revendication 8 dans lequel lesdites résines photosensibles sont de structure à au moins deux couches de résines photosensibles multicouches contenant du PMMA, de la LOR, du PMGI, et du P(MMA-MAA), du polystyrène.

10. Procédé selon la revendication 8 ou la revendication 9 dans lequel une ou plusieurs couches de résine photosensible sont des réserves avec une très faible sensibilité aux rayonnements de faisceaux d'électrons, ce qui signifie des couches ne devant pas être retirées après révélation, par exemple appelées réserve « lift-off » (LOR).

11. Procédé selon la revendication 1 dans lequel la résine photosensible est une feuille ou plaque, de préférence d'une épaisseur supérieure à 5 µm, ou un film de polymère autonome, de préférence d'une épaisseur de 100 nm et plus, au lieu d'une réserve sur un substrat.

12. Procédé selon la revendication 1 dans lequel la résine photosensible est un fil, tube, ou tout matériau de substrat non plan au lieu d'une réserve sur un substrat.

13. Procédé selon la revendication 1 dans lequel la résine photosensible est une plaque et une feuille ou un film mince de polymère qui est stratifié (e), par exemple par ce que l'on appelle impression inversible.

14. Procédé selon la revendication 1 dans lequel la résine photosensible a une épaisseur avec différentes hauteurs de réserve allant de 20 nm à 100 µm, de préférence de 30 nm à 50 µm.

15. Procédé selon la revendication 1 dans lequel les couches contiennent des masses moléculaires initiales différentes, au moins une couche a une masse moléculaire au-dessous et une au-dessus de 10 k, qui ont des transitions vitreuses différentes.
